# EUROPÄISCHE PATENTSCHRIFT

(11) **EP 1 060 515 B1**
(45) Veröffentlichungstag und Bekanntmachung des Hinweises auf die Patenterteilung: **01.08.2007**
(21) Anmeldenummer: 99915477.6
(22) Anmeldetag: 15.02.1999
(51) Int. Cl.: H01L 27/115, H01L 21/8247, H01L 29/788, G11C 16/04

(54) **VERFAHREN ZUR HERSTELLUNG EINER ELEKTRISCH PROGRAMMIERBAREN SPEICHERZELLENANORDNUNG**
METHOD FOR PRODUCING AN ELECTRICALLY PROGRAMMABLE MEMORY CELL ARRANGEMENT
PROCEDE DE FABRICATION D'UNE CONFIGURATION DE CELLULE DE MEMOIRE PROGRAMMABLE ELECTRIQUEMENT

(30) Priorität: 27.02.1998 DE 19808527
(43) Veröffentlichungstag der Anmeldung: 20.12.2000
(73) Patentinhaber: Qimonda AG, 81739 München (DE)
(72) Erfinder: WILLER, Josef, D-85521 Riemerling (DE); HOFMANN, Franz, D-80995 München (DE)
(74) Vertreter: Epping - Hermann - Fischer
(86) Internationale Anmeldenummer: PCT/DE1999/000417
(87) Internationale Veröffentlichungsnummer: WO 1999/044238

(56) Entgegenhaltungen:
- EP-A- 0 562 307
- WO-A-97/36332
- US-A- 4 979 004
- US-A- 5 486 714
- PATENT ABSTRACTS OF JAPAN vol. 016, no. 465 (E-1270), 28. September 1992 (1992-09-28) & JP 04 164372 A (TOSHIBA CORP;OTHERS: 01), 10. Juni 1992 (1992-06-10)
- PATENT ABSTRACTS OF JAPAN vol. 015, no. 106 (E-1044), 13. März 1991 (1991-03-13) & JP 02 310971 A (NEC CORP), 26. Dezember 1990 (1990-12-26)

## Beschreibung

Die Erfindung betrifft ein Verfahren zur Herstellung einer elektrisch programmierbaren Speicherzellenanordnung und.

Bei elektrisch programmierbaren Speichern auf Halbleiterbasis, sogenannten EEPROM's, wird die Information in Form von mindestens zwei unterschiedlichen Einsatzspannungen von Transistoren gespeichert. Zum Auslesen einer Information eines der Transistoren, wird an eine Kontroll-Gateelektrode des Transistors eine Spannung angelegt, die zwischen den zwei Einsatzspannungen liegt. Je nach dem, ob ein Strom durch den Transistor fließt oder nicht, werden die logischen Werte 0 oder 1 ausgelesen.

Durch eine Floating-Gateelektrode, die elektrisch isoliert und zwischen der Kontroll-Gateelektrode und einem Kanalgebiet des Transistors angeordnet ist, kann die Einsatzspannung des Transistors eingestellt werden. Dazu wird ein Spannungsabfall zwischen der Kontroll-Gateelektrode und dem Kanalgebiet oder einem Source/Drain-Gebiet des Transistors erzeugt, der ein Tunneln von Elektronen in die oder aus der Floating-Gateelektrode bewirkt. Eine unterschiedliche Ladung der Floating-Gateelektrode führt zu unterschiedlichen Einsatzspannungen des Transistors.

Der Name der Floating-Gateelektrode rührt daher, daß sie nicht an ein Potential angeschlossen ist, d.h. "floatet". Der Name der Kontroll-Gateelektrode rührt daher, daß sie sowohl die Programmierung steuert, als auch zum Auslesen der Information dient.

In der VLSI-Technologie wird eine Erhöhung der Packungsdichte von Schaltungsanordnungen angestrebt, um Prozeßkosten zu senken und Schaltungsgeschwindigkeiten zu erhöhen.

Um Kurzkanaleffekte bei hoher Packungsdichte zu vermeiden, wird in US 5 486 714 eine elektrisch programmierbare Speicherzellenanordnung vorgeschlagen, bei der Source/Drain-Gebiete eines Transistors, der als Speicherzelle wirkt, an oberen Teilen von zwei sich gegenüberliegenden Flanken einer Vertiefung angeordnet werden. Ein Kanalgebiet des Transistors ist u-förmig und verläuft entlang der zwei Flanken und entlang eines Bodens der Vertiefung. Durch diese Anordnung wird bei hoher Packungsdichte eine große Kanallänge erzielt. Eine Floating-Gateelektrode grenzt an vier Flanken und an den Boden der Vertiefung an. Im Bereich des Kanalgebiets ist die Vertiefung mit einem thermisch gewachsenen Gateoxid versehen. Zur Verkleinerung der Kapazität, die durch die Floating-Gateelektrode und das Kanalgebiet gebildet wird, ist das Gateoxid an den zwei Flanken der Vertiefung etwas dicker als am Boden der Vertiefung. Beim Löschen der Information tunneln Elektronen nur am Boden der Vertiefung. Über der Floating-Gateelektrode ist eine Kontroll-Gateelektrode angeordnet, die durch ein zweites Dielektrikum von der Floating-Gateelektrode getrennt wird. Die Kontroll-Gateelektrode ist Teil einer Wortleitung, die senkrecht zu einer Verbindungslinie zwischen den Source/Drain-Gebieten verläuft. Die Floating-Gateelektrode überlappt außerhalb der Vertiefung die Oberfläche des Substrats. Eines der Source/Drain-Gebiete ist über einen Kontakt mit einer Bitleitung verbunden. Nachteilig ist, daß aufgrund des teilweise dicken Gateoxids nur ein sehr geringer Lesestrom zur Verfügung steht.

Eine weitere Speicherzellenanordnung ist in US 5 392 237 beschrieben. Hier ist die Floating-Gateelektrode ebenfalls in einer Vertiefung angeordnet und grenzt an vier Flanken der Vertiefung an. An den zwei Flanken, an denen die Source/Drain-Gebiete nicht angeordnet sind, sind isolierende Strukturen angeordnet. Das Gateoxid weist eine gleichförmige Dicke auf. Das Source-Gebiet umfaßt einen ersten Teil und einen zweiten Teil. Der erste Teil ist unterhalb des zweiten Teils angeordnet und weist eine kleinere Dotierstoffkonzentration als der zweite Teil auf. Der erste Teil grenzt an das Kanalgebiet an. Der erste Teil und der zweite Teil grenzen an eine Flanke der Vertiefung an.

In US 5 567 635 wird eine elektrisch programmierbare Speicherzellenanordnung beschrieben, bei der eine Speicherzelle einen MOS-FET, eine Floating-Gateelektrode und eine Kontroll-Gateelektrode umfaßt. Die Floating-Gateelektrode ist an vier Flanken und einem Boden einer Vertiefung angeordnet. An zwei sich gegenüberliegenden Flanken der Vertiefung grenzen zwei Source/Drain-Gebiete des MOS-FET an. An die übrigen zwei Flanken der Vertiefung grenzen isolierende Strukturen an. Ein Kanalgebiet ist am Boden der Vertiefung angeordnet. Der MOS-FET ist ein planarer Transistor. Die Floating-Gateelektrode wird durch ein erstes Dielektrikum von dem MOS-FET elektrisch isoliert. Das erste Dielektrikum ist an den zwei Flanken, an die die Source/Drain-Gebiete angrenzen, dünner als am Boden der Vertiefung. Ein Tunneln von Elektronen erfolgt nur an den zwei Flanken der Vertiefung. Die Floating-Gateelektrode wirkt als Gateelektrode des MOS-FET. Die Kontroll-Gateelektrode ist Teil einer Wortleitung, die parallel zu einer Verbindungslinie zwischen den zwei Source/Drain-Gebieten verläuft.

In JP 1-115164 wird eine elektrisch programmierbare Speicherzellenanordnung beschrieben, bei der Source/Drain-Gebiete eines Transistors an Flanken einer Vertiefung angrenzen. Die Flanken und ein Boden der Vertiefung sind mit einem ersten Dielektrikum versehen. An das erste Dielektrikum grenzt eine Floating-Gateelektrode, auf der ein zweites Dielektrikum und eine Kontroll-Gateelektrode angeordnet sind. Beim Schreiben und Auslesen von Information tunneln Elektronen an oberen und an unteren Kanten der Vertiefung zwischen der Floating-Gateelektrode und den Source/Drain-Gebieten des Transistors.

Das Koppelverhältnis ist das Verhältnis zwischen einer Kapazität, die durch eine Kontroll-Gateelektrode und einer Floating-Gateelektrode gebildet wird, und einer Kapazität, die durch die Floating-Gateelektrode und ein Kanalgebiet sowie Source/Drain-Gebiete eines Transistors, also durch die Floating-Gateelektrode und das Substrat, gebildet wird. Das Koppelverhältnis sollte möglichst groß sein, damit das Tunneln schon bei niedrigen Betriebsspannungen ausgelöst werden kann. Weitere Verfahren sind in den Dokumenten JP4164372 und WO 9736 332 beschrieben

Der Erfindung liegt das Problem zugrunde, ein Verfahren zur Herstellung einer elektrisch programmierbaren Speicherzellenanordnung anzugeben, die im Vergleich zum Stand der Technik ein großes Koppelverhältnis aufweist und trotzdem mit hoher Packungsdichte herstellbar ist.

Dieses Problem wird gelöst durch ein Verfahren zur Herstellung einer elektrisch programmierbaren Speicherzellenanordnung nach Anspruch 1. Weitere Ausgestaltungen der Erfindung gehen aus den übrigen Ansprüchen hervor.

Bei einem erfindungsgemäßen Verfahren zur Herstellung einer elektrisch programmierbaren Speicherzellenanordnung umfaßt ein Substrat Speicherzellen mit jeweils einem planaren Transistor. Ein Kanalgebiet des Transistors ist im Substrat an mindestens einem Teil eines Bodens einer Vertiefung, der mit einem ersten Dielektrikum versehen ist, angeordnet. Vorzugsweise grenzt das Kanalgebiet an den gesamten Boden der Vertiefung an. Der Boden der Vertiefung ist im Bereich des Kanalgebiets mit einem ersten Dielektrikum versehen. An das Kanalgebiet grenzen zwei Source/Drain-Gebiete des Transistors an, wobei ein zu einer Oberfläche des Substrats paralleler Querschnitt durch das Kanalgebiet die zwei Source/Drain-Gebiete schneidet. Dieser Querschnitt verläuft in der Nähe des Bodens der Vertiefung. Teile der zwei Source/Drain-Gebiete sind also in derselben Höhe wie das Kanalgebiet angeordnet. Eine Floating-Gateelektrode des Transistors grenzt an das erste Dielektrikum an und ist teilweise an mindestens zwei sich gegenüberliegende Flanken der Vertiefung angeordnet. Die Vertiefung wird durch die Floating-Gateelektrode verengt, aber nicht ausgefüllt. Über der Floating-Gateelektrode ist eine Kontroll-Gateelektrode angeordnet, die durch ein zweites Dielektrikum von der Floating-Gateelektrode isoliert ist. Die Kontroll-Gateelektrode ist mit einer Wortleitung elektrisch verbunden. Die Dicke des ersten Dielektrikums ist so bemessen, daß Elektronen beim Programmieren und beim Löschen der Speicherzelle durch sie tunneln können. Die Source/Drain-Gebiete grenzen an die zwei Flanken der Vertiefung an. Die zwei Source/Drain-Gebiete reichen also von der Oberfläche des Substrats bis in einen Bereich des Bodens der Vertiefung. Die zwei Flanken der Vertiefung sind mit einer Isolation versehen, um eine Kapazität, die durch die Floating-Gateelektrode und die Source/Drain-Gebiete gebildet wird, zu vermeiden. Die Dicke der Isolation ist mindestens so bemessen, daß beim Programmieren kein Tunneln von Elektronen durch die Isolation in oder aus der Floating-Gateelektrode erfolgt.

Eine Kapazität, die durch die Kontroll-Gateelektrode und die Floating-Gateelektrode gebildet wird, ist größer als eine Kapazität, die durch die Floating-Gateelektrode und das Kanalgebiet gebildet wird, da die Floating-Gateelektrode im Gegensatz zum Kanalgebiet auch an mindestens zwei Flanken der Vertiefung angeordnet ist, und somit eine Fläche zwischen der Kontroll-Gateelektrode und der Floating-Gateelektrode größer ist als eine Fläche zwischen dem Kanalgebiet und der Floating-Gateelektrode. Eine Kapaziät zwischen der Floating-Gateelektrode und den Source/Drain-Gebieten ist vernachlssigbar. Die Source/Drain-Gebiete tragen nicht zum Koppelverhältnis bei. Das Koppelverhältnis ist folglich groß. Da die Vergrößerung in vertikaler Richtung erfolgt, kann eine hohe Pakkungsdichte realisiert werden.

Zur Prozeßvereinfachung und zur Erhöhung der Packungsdichte ist es vorgesehen, dass Kontroll-Gateelektroden Wortleitungen bilden.

Die Vertiefung kann im Substrat oder in einer auf dem Substrat angeordneten Schicht erzeugt werden. Sie kann auch teilweise in einer Schicht und im Substrat erzeugt werden.

Die Isolation ist beispielsweise spacerförmig und kann durch Abscheiden und Rückätzen von isolierendem Material erzeugt werden. Die Dicke der Isolation beträgt z. B. 30 nm.

Um die Herstellung möglichst kompatibel zur Herstellung von herkömmlichen planaren Transistoren zu machen, ist es vorgesehen, dass die Vertiefung im Substrat erzeugt wird.

Um eine Kapazität, die durch die Wortleitung und jeweils eines der zwei Source/Drain-Gebiete gebildet wird, zu vermeiden, sind die zwei Source/Drain-Gebiete vorzugsweise so angeordnet, daß keine Verbindungslinie zwischen ihnen parallel zum Verlauf der Wortleitung ist und der Stromfluß zwischen ihnen quer zur Wortleitung verläuft. Das heißt, daß die Wortleitung im wesentlichen parallel zu Schnittlinien, die durch die Oberfläche des Substrats und die zwei Flanken der Vertiefung gebildet werden, verläuft. Aus demselben Grund ist es vorteilhaft, wenn die Wortleitung die zwei Source/Drain-Gebiete nicht überlappt, d.h. zwischen den zwei Source/Drain-Gebieten angeordnet ist.

Die zwei Source/Drain-Gebiete werden durch Implantation der Oberfläche des Substrats erzeugt. In einer nicht beanspruchten Ausführungsform wird als Teil des Substrats eine in situ epitaktisch aufgewachsene Schicht erzeugt und strukturiert. In einer nicht beanspruchten Ausführungsform besteht darin, Dotierstoff aus einer Dotierstoffquelle in das Substrat diffundiert.

Die Vertiefung kann ein Graben sein, dessen Länge größer ist als seine Breite. In diesem Fall sind im Graben mehrere Floating-Gateelektroden verschiedener Transistoren angeordnet.

Zur Erhöhung der Kapazität zwischen der Kontroll-Gateelektrode und der Floating-Gateelektrode ist es vorteilhaft, wenn die Vertiefung lochartig ist und z.B. zwei weitere Flanken aufweist, an die die Floating-Gateelektrode ebenfalls angrenzt. Dadurch vergrößert sich die Fläche zwischen der Floating-Gateelektrode und der Kontroll-Gateelektrode im Vergleich zur Fläche zwischen Floating-Gateelektrode und dem Kanalgebiet noch mehr. Das Koppelverhältnis erhöht sich.

Um zu verhindern, daß sich zwischen entlang der Wortleitung benachbarten Source/Drain-Gebieten verschiedener Transistoren aufgrund der Wortleitung ein Kanalstrom ausbildet, ist es vorgesehen, zwischen entlang der Wortleitung benachbarten Vertiefungen erste isolierende Strukturen anzuordnen. In diesem Fall ist die Vertiefung zwischen zwei der ersten isolierenden Strukturen angeordnet, die die zwei weiteren Flanken der Vertiefung bilden. Die Wortleitung überlappt die ersten isolierenden Strukturen und eine Verbindungslinie zwischen den zwei ersten isolierenden Strukturen verläuft parallel zu ihr.

Die ersten isolierenden Strukturen können beispielsweise erzeugt werden, indem vor Erzeugung der Vertiefung im wesentlichen parallel zueinander verlaufende Gräben erzeugt werden, die mit isolierendem Material aufgefüllt werden. Die ersten isolierenden Strukturen füllen die Gräben auf. Durch maskiertes Ätzen können dann die Vertiefungen zwischen den Gräben erzeugt werden. Um zu gewährleisten, daß die zwei weiteren Flanken der Vertiefung durch die ersten isolierenden Strukturen gebildet werden, ist es vorteilhaft, wenn beim maskierten Ätzen eine streifenförmige Maske verwendet wird, deren Streifen quer zu den Gräben verlaufen. Alternativ bedeckt die Maske nur jene Bereiche des Substrats nicht, in denen die Vertiefungen erzeugt werden.

Eine andere Möglichkeit die ersten isolierenden Strukturen zu erzeugen, besteht darin, die Vertiefungen durch teilweises Entfernen vom isolierenden Material in den Gräben zu erzeugen. In diesem Fall sind die ersten isolierenden Strukturen säulenförmig.

Die Floating-Gateelektrode wird durch Strukturierung einer leitenden ersten Schicht, die die Vertiefung verengt, aber nicht ausfüllt, erzeugt.

Es ist vorteilhaft, wenn die Floating-Gateelektrode nicht nennenswert aus der Vertiefung herausragt. In diesem Fall kann zur Strukturierung der leitenden ersten Schicht die leitende erste Schicht planarisiert werden, bis außerhalb der Vertiefung befindliche Teile der leitenden ersten Schicht entfernt wurden. Auf diese Weise ist für die Erzeugung der Floating-Gateelektrode keine Maske erforderlich, was den Prozeß vereinfacht. Zum Planarisieren der leitenden ersten Schicht kann Planarisierungsmaterial abgeschieden werden, das gleichzeitig mit der leitenden ersten Schicht planarisiert wird. Nachdem die außerhalb der Vertiefung befindlichen Teile der leitenden ersten Schicht entfernt werden, kann übrigbleibendes Planarisierungsmaterial entfernt werden.

Zur Vermeidung von Kurzkanaleffekten ist es vorgesehen, dass die zwei Source/Drain-Gebiete jeweils einen ersten Teil und einen daran angrenzenden zweiten Teil umfassen. Erste Teile der zwei Source/Drain-Gebiete sind jeweils an eine der zwei Flanken der Vertiefung und angrenzend an das Kanalgebiet angeordnet und weisen eine niedrigere Dotierstoffkonzentration als zweite Teile der Source/Drain-Gebiete auf, die weder an die Flanken der Vertiefung noch an das Kanalgebiet angrenzen.

Die zweiten Teile der Source/Drain-Gebiete werden durch Implantation mit Hilfe einer Maske erzeugt Zur Prozeßvereinfachung ist es vorgesehen, dass die Maske aus der Wortleitung und aus entlang der Wortleitung angrenzenden Spacer besteht. Die Spacer werden ohne großen Aufwand erzeugt, indem nach Erzeugung der Wortleitung Material abgeschieden und rückgeätzt wird.

Die Spacer können entfernt oder stehengelassen werden. Werden die Spacer stehengelassen, so ist es vorteilhaft, wenn die Spacer aus isolierendem Material erzeugt werden, da dadurch eine Kapazität zwischen der Wortleitung und den zwei Source/Drain-Gebieten vermieden wird.

Um die Herstellung möglichst kompatibel zur Herstellung von herkömmlichen planaren Transistoren zu machen, ist es vorgesehen, dass die ersten Teile der zwei Source/Drain-Gebiete durch Implantation erzeugt werden, wobei die Wortleitung als Maske dient. In diesem Fall werden die Spacer erst nach Erzeugung der ersten Teile der zwei Source/Drain-Gebiete erzeugt.

In einer nicht beanspruchten Ausführungsform werden Die ersten Teile der Source/Drain-Gebiete vor Erzeugung der Vertiefung erzeugt Beispielsweise entstehen sie aus einer dotierten Schicht des Substrats, die durch die Vertiefung und die ersten isolierenden Strukturen strukturiert wird.

Quer zur Wortleitung verläuft eine Bitleitung. Entlang der Bitleitung benachbarte Transistoren können in Reihe (NAND-Architektur) oder parallel (NOR-Architektur) geschaltet sein. Sind die besagten Transistoren in Reihe geschaltet, so bilden sie die Bitleitung. Sind die besagten Transistoren parallel zueinander geschaltet, so ist jeweils ein Source/Drain-Gebiet dieser Transistoren mit der Bitleitung verbunden. Die Verbindung geschieht beispielsweise über einen Kontakt.

In beiden Fällen ist es zur Erhöhung der Packungsdichte vorteilhaft, wenn jeweils zwei der entlang der Bitleitung zueinander benachbarten Transistoren ein gemeinsames Source/Drain-Gebiet aufweisen.

Es ist vorgesehen, dass in dem Substrat eine Peripherie der Speicherzellenanordnung angeordnet wird, die planare Transistoren und/oder planare Hochvolt-Transistoren umfaßt. Hochvolt-Transistoren werden mit hohen Spannungen, z.B. 18 Volt, betrieben und benötigen große Kanallängen. Die Hochvolt-Transistoren schalten z.B. Programmierspannungen, die höher als die Lesespannung sind. Sie dienen zum Schreiben oder Löschen der Speicherzellen.

Zur Prozeßvereinfachung ist es vorgesehen, dass die planaren Transistoren und die planaren Hochvolt-Transistoren der Peripherie gleichzeitig mit den Transistoren der Speicherzellen erzeugt werden.

Die ersten isolierenden Strukturen werden zusammen mit zweiten isolierenden Strukturen der Transistoren der Peripherie und mit dritten isolierenden Strukturen der Hochvolt-Transistoren der Peripherie erzeugt. Die zweiten isolierenden Strukturen umgeben jeweils einen der Transistoren der Peripherie. Die dritten isolierenden Strukturen umgeben jeweils einen der Hochvolt-Transistoren der Peripherie.

Des weiteren wird nach Erzeugung eines Gatedielektrikums des Transistors der Peripherie und eines Gatedielektrikums des Hochvolt-Transistors der Peripherie eine zweite Schicht aufgebracht und strukturiert, wodurch gleichzeitig die Kontroll-Gateelektrode als Teil der Wortleitung, eine Gateelektrode des Transistors der Peripherie und eine Gateelektrode des Hochvolt-Transistors der Peripherie entstehen.

Die ersten Teile der zwei Source/Drain-Gebiete des Transistors der Speicherzelle, erste Teile von Source/Drain-Gebieten des Transistors der Peripherie und erste Teile von Source/Drain-Gebieten des Hochvolt-Transistors der Peripherie werden gleichzeitig durch Implantation erzeugt, wobei die Wortleitung, die Gateelektrode des Transistors der Peripherie und die Gateelektrode des Hochvolt-Transistors der Peripherie als Masken wirken, wie es im herkömmlichen Verfahren zur Erzeugung von planaren Transistoren üblich ist. Sämtliche erste Teile der Source/Drain-Gebiete sind niedriger dotiert als zweite Teile der Source/Drain-Gebiete. Die ersten Teile grenzen an zugehörige Kanalgebiete an, wodurch Kurzkanaleffekte unterdrückt werden.

Die zweiten Teile der zwei Source/Drain-Gebiete des Transistors der Speicherzelle, zweite Teile der Source/Drain-Gebiete des Transistors der Peripherie und zweite Teile der Source/Drain-Gebiete des Hochvolt-Transistors der Peripherie werden gleichzeitig erzeugt, wobei die Spacer und weitere Spacer, die gleichzeitig mit den Spacern an Flanken der Gateelektrode des Transistors der Peripherie und der Gateelektrode des Hochvolt-Transistors der Peripherie erzeugt werden, als Maske wirken. Da beim Hochvolt-Transistor Kurzkanaleffekte besonders kritisch sind, ist es vorteilhaft, dabei eine z.B. stegförmige Maske zu verwenden, die die Gateelektrode des Hochvolt-Transistors, die zugehörigen Spacer und einen umgebenden Bereich bedeckt, um die ersten Teile der Source/Drain-Gebiete des Hochvolt-Transistors besonders groß zu gestalten.

Der Transistor der Speicherzelle, der Transistor der Peripherie und der Hochvolt-Transistor der Peripherie können n-Kanal- oder p-Kanal-Transistoren sein.

Im folgenden wird eine mögliche Betriebsweise der elektrisch programmierbaren Speicherzellen in einer nicht beanspruchten Ausführungsform beschrieben.

Im Fall der NOR-Architektur wird zum Schreiben des logischen Werts 1 auf einen Transistor die zugehörige Wortleitung auf eine Spannung von -12 Volt und die dazugehörige Bitleitung auf eine Spannung von 5 Volt gelegt. Die übrigen Wortleitungen und die übrigen Bitleitungen liegen auf 0 Volt. Aufgrund des Spannungsabfalls zwischen der Wortleitung, d.h. der Kontroll-Gateelektrode des Transistors und der Bitleitung, d.h. einem Source/Drain-Gebiet des Transistors, tunneln Elektronen durch das erste Dielektrikum von der Floating-Gateelektrode in das Source/Drain-Gebiet. Beim Löschen liegt an der Bitleitung eine Spannung von 0 Volt an, während die Wortleitung auf 17 Volt gelegt wird, so daß Elektronen aus dem Kanalgebiet in die Floating-Gateelektrode tunneln können. Dies entspricht dem logischen Wert 0.

Im Fall der NAND-Architektur wird der Transistor programmiert, indem an die Wortleitung eine Spannung von 17 Volt angelegt wird, während die Bitleitung auf 0 Volt bleibt. Damit entlang der Wortleitung benachbarte Transistoren nicht ebenfalls programmiert werden, können die benachbarten Bitleitungen auf eine Spannung von ca. 8 Volt gelegt werden. Das Löschen kann dadurch erfolgen, daß die Wortleitungen auf 0 Volt gelegt werden, während das Kanalgebiet über die Wanne auf ca. 16 Volt gelegt wird.

Zum Auslesen der Information des Transistors wird im Fall der NOR-Architektur die zugehörige Wortleitung auf eine Spannung von ca. 2,5 Volt gelegt, die zwischen den zwei möglichen Einsatzspannungen des Transistors, entsprechend den logischen Werten 0 oder 1, liegt. Über die Bitleitung wird bewertet, ob ein Strom durch den Transistor fließt oder nicht.

Im Fall der NAND-Architektur wird zum Auslesen der Information des Transistors die Wortleitung auf ca. 2,5 Volt gelegt, während die übrigen Wortleitungen auf ca. 5 Volt gelegt werden. Dann wird bewertet, ob bei ca. 5 Volt an der Bitleitung ein Strom fließt oder nicht.

Im folgenden wird ein Ausführungsbeispiel der Erfindung, das in den Figuren dargestellt ist, näher erläutert.
- Figur 1a: zeigt einen Ausschnitt aus einem Querschnitt durch ein Substrat im Bereich von Speicherzellen, nachdem eine erste Maske, erste isolierende Strukturen (in Figur 5d dargestellt), eine zweite isolierende Struktur (in Figur 1b dargestellt), eine dritte isolierende Struktur (in Figur 1c dargestellt), eine erste Wanne, eine zweite Wanne und eine dritte Wanne erzeugt wurden.
- Figur 1b: zeigt einen Ausschnitt aus einem Querschnitt durch das Substrat im Bereich einer Peripherie der Speicherzellenanordnung nach den Prozeßschritten aus Figur 1a.
- Figur 1c: zeigt einen weiteren Ausschnitt aus einem Querschnitt durch das Substrat im Bereich der Peripherie nach den Prozeßschritten aus Figur 1a.
- Figur 2: zeigt den Ausschnitt aus Figur 1a, nachdem Vertiefungen, eine Isolation, ein erstes Dielektrikum und eine leitende erste Schicht erzeugt wurden.
- Figur 3: zeigt den Ausschnitt aus Figur 2, nachdem eine Floating-Gateelektrode und eine ONO-Schicht erzeugt wurden.
- Figur 4a: zeigt den Ausschnitt aus Figur 3, nachdem die ONO-Schicht und die erste Maske im Bereich der Peripherie entfernt wurden und ein Gatedielektrikum eines Transistors der Peripherie, ein Gatedielektrikum eines Hochvolt-Transistors der Peripherie und eine zweite Schicht erzeugt wurden.
- Figur 4b: zeigt den Ausschnitt aus Figur 1b nach den Prozeßschritten aus Figur 4a.
- Figur 4c: zeigt den Ausschnitt aus Figur 1c nach den Prozeßschritten aus Figur 4a.
- Figur 5a: zeigt den Ausschnitt aus Figur 4a, nachdem eine Kontroll-Gateelektrode, eine Gateelektrode des Transistors der Peripherie, eine Gateelektrode des Hochvolt-Transistors der Peripherie, erste Teile von Source/Drain-Gebieten von Transistoren von Speicherzellen, erste Teile von Source/Drain-Gebieten des Transistors der Peripherie, erste Teile der Source/Drain-Gebiete des Hochvolt-Transistors der Peripherie und ein Postoxid erzeugt wurden.
- Figur 5b: zeigt den Ausschnitt aus Figur 4b nach den Prozeßschritten aus Figur 5a.
- Figur 5c: zeigt den Ausschnitt aus Figur 4c nach den Prozeßschritten aus Figur 4c.
- Figur 5d: zeigt einen zum Querschnitt aus Figur 5a senkrechten Querschnitt durch das Substrat nach den Prozeßschritten aus Figur 5a.
- Figur 6a: zeigt den Ausschnitt aus Figur 5a, nachdem erste Spacer, zweite Spacer, dritte Spacer, zweite Teile der Source/Drain-Gebiete, zweite Teile der Source/Drain-Gebiete des Transistors der Peripherie, zweite Teile des Hochvolt-Transistors der Peripherie, leitende Strukturen, leitende Strukturen des Transistors der Peripherie und leitende Strukturen des Hochvolt-Transistors der Peripherie erzeugt wurden. Ferner ist die Lage eines Stegs aus Fotolack dargestellt, der vor der Erzeugung der leitenden Strukturen entfernt wurde.
- Figur 6b: zeigt den Ausschnitt aus Figur 5b nach den Prozeßschritten aus Figur 6a.
- Figur 6c: zeigt den Querschnitt aus Figur 5c nach den Prozeßschritten aus Figur 6a.
- Figur 7a: zeigt einen Ausschnitt aus einer Aufsicht auf eine Speicherzellenanordnung in NAND-Architektur.
- Figur 7b: zeigt einen Ausschnitt aus einer Aufsicht auf eine Speicherzellenanordnung in NOR-Architektur.

Die Figuren sind nicht maßstabsgerecht.

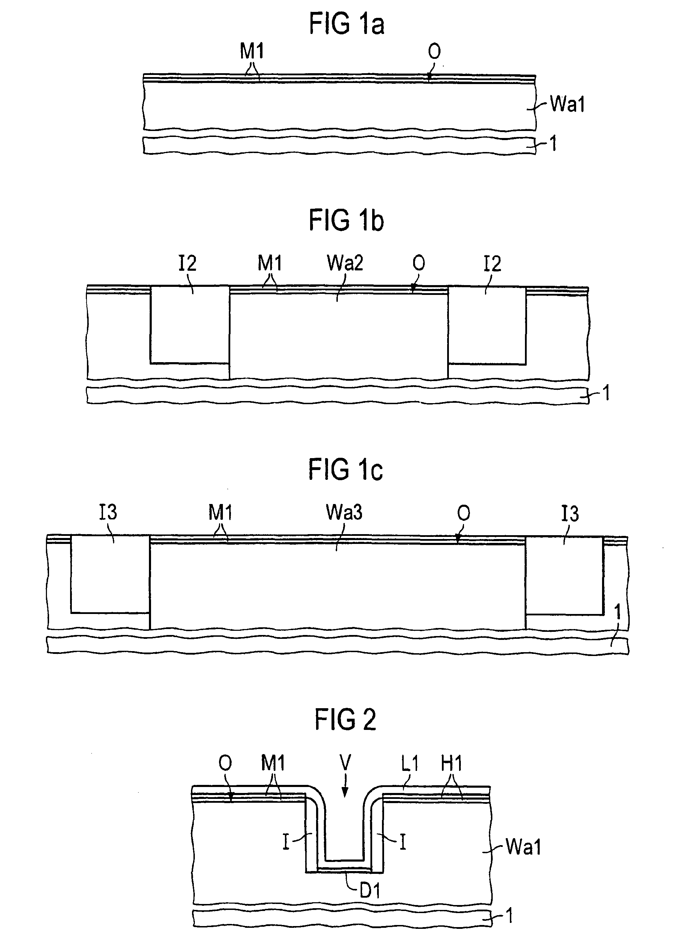

Ausgangsmaterial ist ein p-dotiertes Substrat 1 aus Silizium. Zur Erzeugung einer ersten Maske M1 wird SiO₂ in einer Dicke von ca.20 nm abgeschieden und darüber Siliziumnitrid in einer Dicke von ca.40 nm abgeschieden und durch ein fotolithografisches Verfahren so strukturiert, daß die erste Maske M1 in einem ersten Bereich längliche rechteckige Gebiete nicht bedeckt und in einem zweiten Bereich ein Gebiet um einen zu erzeugenden Transistor einer Peripherie einer Speicherzellenanordnung und ein Gebiet um einen zu erzeugenden Hochvolt-Transistor der Peripherie nicht bedeckt. Mit Hilfe der ersten Maske M1 wird Silizium ca. 250 nm tief geätzt. Als Ätzmittel ist z. B. HBr geeignet. Durch Abscheiden von SiO₂ in einer Dicke von ca. 300 nm und anschließendem chemisch-mechanischem Polieren, bis die erste Maske M1 freigelegt wird, entstehen im ersten Bereich erste isolierende Strukturen I1 (vgl. Figur 5d) und im zweiten Bereich eine zweite isolierende Struktur I2 (vgl. Figur 1b) und eine dritte isolierende Struktur I3 (vgl. Figur 1c). Entlang einer in einer Oberfläche O des Substrats 1 verlaufenden y-Achse Y benachbarte erste isolierende Strukturen I1 weisen in Richtung der y-Achse Y einen Abstand von ca. 200 nm voneinander auf. Eine zur y-Achse Y parallele Abmessung der ersten isolierenden Strukturen I1 beträgt ca. 200 nm. Entlang einer in der Oberfläche O und senkrecht zur y-Achse Y verlaufenden x-Achse X benachbarte erste isolierende Strukturen I1 weisen einen Abstand von ca. 200 nm voneinander auf. Eine zur x-Achse X parallele Abmessung der ersten isolierenden Strukturen I1 beträgt ca. 3200 nm. Endpunkte der entlang der y-Achse Y benachbarten ersten isolierenden Strukturen I1 sind entlang einer zur y-Achse Y parallelen Linie angeordnet. Endpunkte der entlang der x-Achse X benachbarten ersten isolierenden Strukturen I1 sind entlang einer zur x-Achse X parallelen Linie angeordnet.

Durch maskierte Implantationen mit p-dotierenden Ionen werden im ersten Bereich eine ca. 400nm tiefe erste Wanne Wa1 und im zweiten Bereich eine zweite ca. 200 nm tiefe Wanne Wa2 und eine ca. 200 nm tiefe dritte Wanne Wa3 erzeugt. Die zweite Wanne Wa2 wird von der zweiten isolierenden Struktur I2 umgeben, und die dritte Wanne Wa3 wird von der dritten isolierenden Struktur I3 umgeben (s. Figur 1a,b,c). Die Dotierstoffkonzentration der ersten Wanne Wa1, der zweiten Wanne Wa2 und der dritten Wanne Wa3 beträgt ca. 10¹⁷ *cm⁻³.*

Mit Hilfe einer zweiten Maske (nicht dargestellt), deren Streifen parallel zur y-Achse Y verlaufen, werden im ersten Bereich des Substrats 1 zwischen den ersten isolierenden Strukturen I1 ca. 200 nm tiefe Vertiefungen V erzeugt. Als Ätzmittel ist z.B. HBr geeignet. Jede Vertiefung V grenzt mit zwei seiner Flanken an zwei zueinander benachbarte erste isolierende Strukturen I1 an. Eine zur x-Achse X parallele Abmessung der Vertiefungen V beträgt ca. 200 nm. Parallel zur x-Achse X benachbarte Vertiefungen V weisen einen Abstand von ca. 200 nm auf (s. Figur 2).

Zum Entfernen von Ätzrückständen wird ein ca. 10 nm dickes Opferoxid (nicht dargestellt) thermisch aufgewachsen und anschließend mit z. B. HF wieder entfernt.

Zur Erzeugung einer Isolation I an den Flanken der Vertiefungen V wird in einem TEOS-Verfahren SiO₂ in einer Dicke von ca. 30 nm abgeschieden und rückgeätzt, bis die erste Maske M1 freigelegt wird (s. Figur 2). Die Isolation I ist spacerförmig und ist ca. 30 nm dick.

Anschließend wird durch thermische Oxidation ein ca. 8 nm dickes erstes Dielektrikum D1, das als Tunneloxid wirkt, an Böden der Vertiefungen V erzeugt (s. Figur 2).

Durch Abscheiden von in situ dotiertem Polysilizium wird eine ca. 20 nm dicke leitende erste Schicht L1 erzeugt (s. Figur 2).

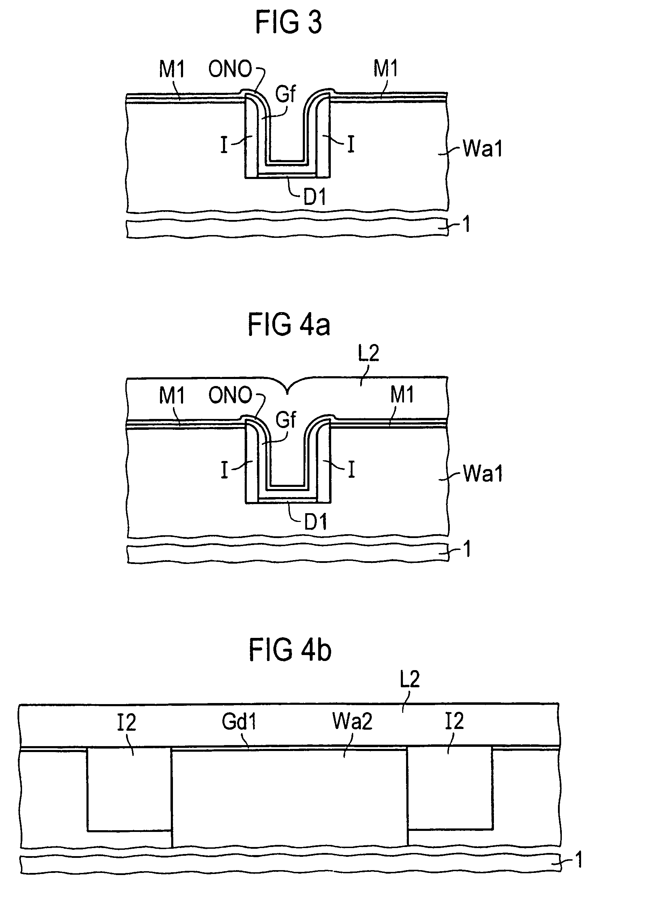

Anschließend wird Planarisierungs-Lack in einer Dicke von ca. 500 nm abgeschieden und durch chemisch-mechanisches Polieren planarisiert, bis die leitende erste Schicht L1 teilweise freigelegt wird. Anschließend wird die leitende erste Schicht L1 zusammen mit dem Planarisierungs-Lack chemisch-mechanisch poliert, bis die erste Maske M1 freigelegt wird. Dadurch werden außerhalb der Vertiefung V liegende Teile der leitenden ersten Schicht L1 entfernt. Übrigbleibende Teile der leitenden ersten Schicht L1 bedecken die vier Flanken und den Boden jeder Vertiefung V und bilden Floating-Gateelektroden Gf von Transistoren von Speicherzellen (s. Figur 3). Übrigbleibende Teile des Planarisierungs-Lacks werden entfernt. Mit z.B. Phosphorsäure wird Siliziumnitrid der ersten Maske M1 entfernt.

Zur Erzeugung einer ONO-Schicht ONO wird zunächst ca. 3 nm dickes thermisches SiO₂ aufgewachsen. Anschließend wird Siliziumnitrid in einer Dicke von ca. 10 nm abgeschieden und solange aufoxidiert, bis sich eine oxidäquivalente Dicke von ca. 15nm ergibt. Dadurch entsteht eine dreiteilige ONO-Schicht ONO, bei der Siliziumnitrid zwischen Oxiden angeordnet ist (s. Figur 3). Durch ein fotolithografisches Verfahren wird die ONO-Schicht ONO im zweiten Bereich des Substrats 1 entfernt. Als Ätzmittel ist z.B. HF geeignet. Anschließend wird die erste Maske M1 im zweiten Bereich des Substrats 1 entfernt. Als Ätzmittel sind z.B. HF geeignet.

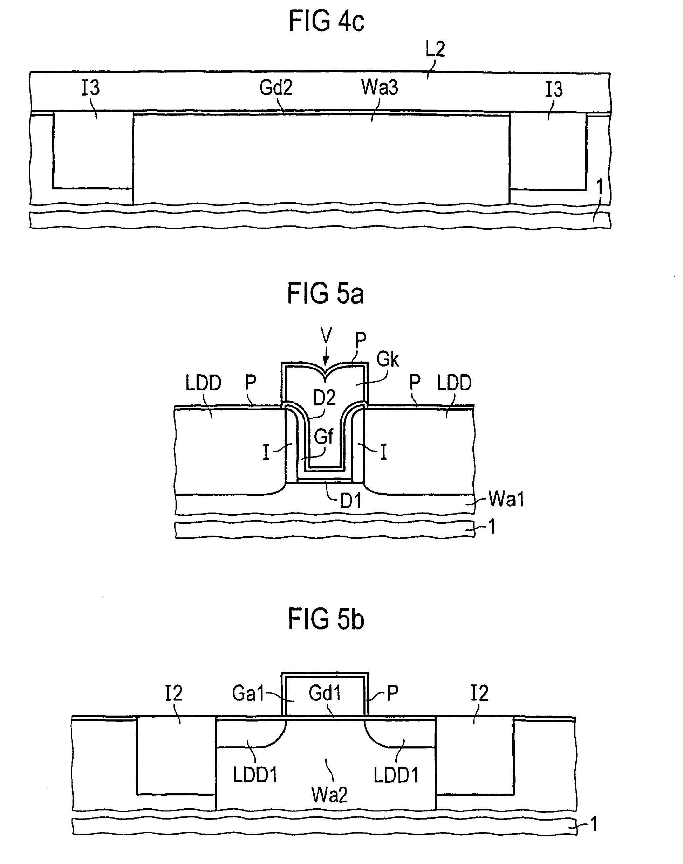

Durch thermische Oxidation wird SiO₂ in einer Dicke von ca. 25 nm aufgewachsen. Auf dem Gebiet, das von der dritten isolierenden Struktur I3 umgeben wird, entsteht dadurch ein Gatedielektrikum Gd2 des Hochvolt-Transistors der Peripherie. Durch ein fotolithografisches Verfahren wird in dem Gebiet, das von der zweiten isolierenden Struktur I2 umgeben wird, SiO₂ mit z. B. HF durch isotropes Ätzen entfernt. Anschließend wird durch thermische Oxidation SiO₂ in einer Dicke von ca. 7 nm im von der zweiten isolierenden Struktur I2 umschlossenen Gebiet aufgewachsen, wodurch ein Gatedielektrikum Gd1 des Transistors der Peripherie entsteht. Das Gatedielektrikum Gd2 des Hochvolt-Transistors der Peripherie wird dabei etwas dicker (s. Figur 4b und 4c). Zur Erzeugung einer zweiten Schicht L2 wird undotiertes Polysilizium in einer Dicke von ca. 100 nm abgeschieden (s. Figur 4a, b, c).

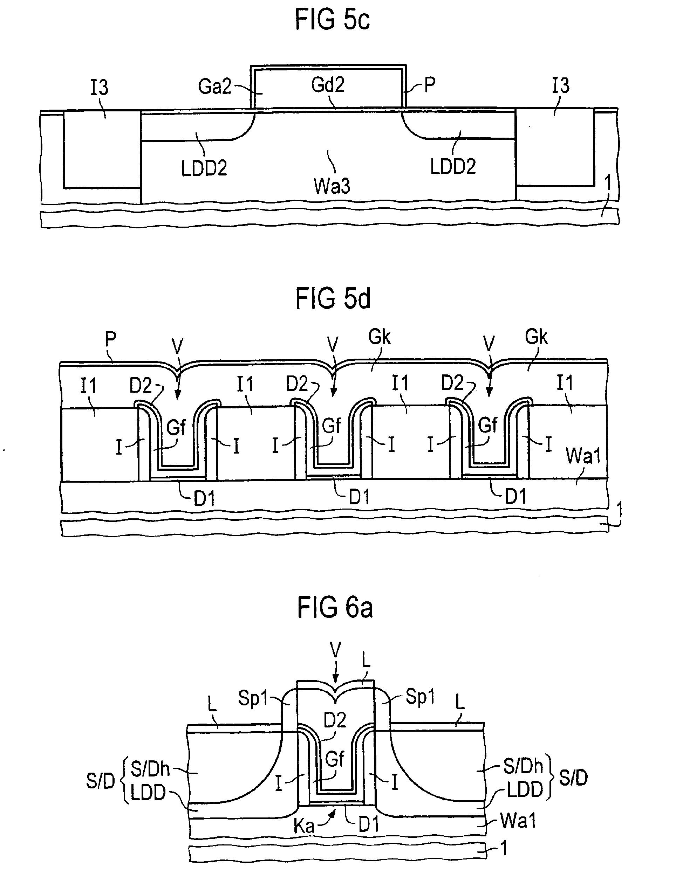

Mit Hilfe einer dritten Maske (nicht dargestellt), die im ersten Bereich des Substrats 1 streifenförmig ist, und deren Streifen parallel zur y-Achse Y verlaufen und die Vertiefungen V bedecken, wird die zweite Schicht L2 mit z.B. HBr hochselektiv zu SiO₂ geätzt, wobei die ONO-Schicht ONO als Ätzstop wirkt. Dabei entstehen aus der zweiten Schicht L2 Kontroll-Gateelektroden Gk, die parallel zur y-Achse Y verlaufende Wortleitungen bilden. Mit Hilfe der dritten Maske wird die ONO-Schicht ONO mit z.B. HF strukturiert (s. Figur 5a). Dabei entstehen aus der ONO-Schicht ONO zweite Dielektrika D2 (s. Figur 5d). Ebenfalls mit Hilfe der dritten Maske werden eine Gateelektrode Ga1 des Transistors der Peripherie und eine Gateelektrode Ga2 des Hochvolt-Transistors der Peripherie erzeugt (s. Figur 5b und c).

Um unter anderem die Gefahr von Kurzschlüssen zwischen Wortleitungen und dem Substrat 1 zu verkleinern, wird durch thermische Oxidation ein sogenanntes Postoxid P aufgewachsen (siehe Fig. 5a, b, c).

Anschließend werden durch maskierte Implantationen mit n-dotierenden Ionen ca. 200 nm tiefe erste Teile LDD von Source/Drain-Gebieten S/D der Transistoren der Speicherzellen, ca. 100 nm tiefe erste Teile LDD1 von Source/Drain-Gebieten S/D1 des Transistors der Peripherie und ca. 100 nm tiefe erste Teile LDD2 von Source/Drain-Gebieten S/D2 des Hochvolt-Transistors der Peripherie erzeugt (s. Figur 5a,b,c). Die Wortleitungen, die Gateelektrode Ga1 des Transistors der Peripherie und die Gateelektrode Ga2 des Hochvolt-Transistors der Peripherie dienen als Maske und werden dabei implantiert. Um in den Figuren nicht gezeigte Bereiche des Substrats 1 vor der Implantation zu schützen, kann zusätzlich eine Fotolackmaske verwendet werden.

Die Dotierstoffkonzentration der ersten Teile LDD der Source/Drain-Gebiete S/D der Transistoren der Speicherzellen, der ersten Teile LDD1 der Source/Drain-Gebiete S/D1 des Transistors der Peripherie und der ersten Teile LDD2 der Source/Drain-Gebiete S/D2 des Hochvolt-Transistors der Peripherie beträgt ca. 10¹⁸ cm⁻³. Diese ersten Teile LDD, LDD1, LDD2 entstehen also selbstjustiert bezüglich der Wortleitungen, der Gateelektrode Ga1 des Transistors der Peripherie und der Gateelektrode Ga2 des Hochvolt-Transistors der Peripherie. Die ersten Teile LDD der Source/Drain-Gebiete S/D der Transistoren der Speicherzellen grenzen jeweils an eine von zwei sich gegenüber liegenden Flanken der Vertiefungen V an und reichen bis in einen Bereich der Böden der Vertiefungen V.

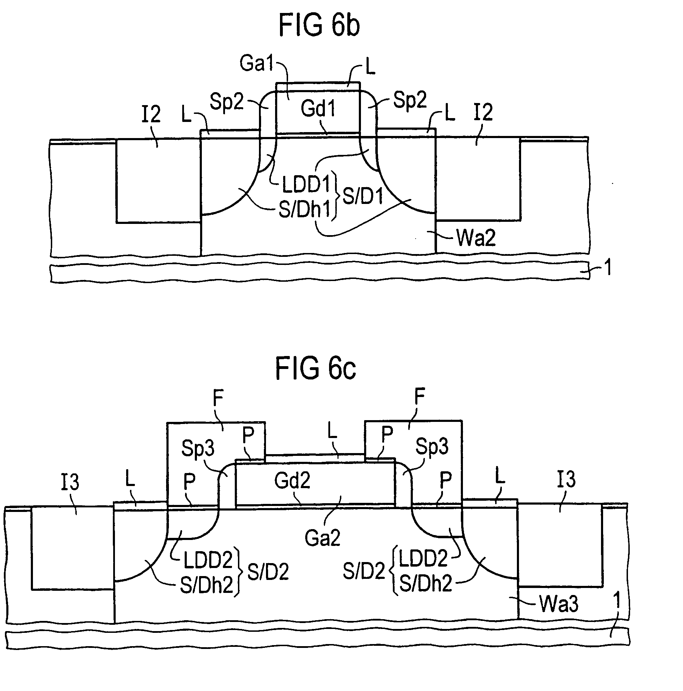

Zur Erzeugung von ersten Spacern Sp1, zweiten Spacern Sp2 und dritten Spacern Sp3 wird SiO₂ in einer Dicke von ca. 50 nm abgeschieden und rückgeätzt. Dadurch entstehen die ersten Spacer Sp1 entlang Flanken der Wortleitungen (s. Figur 6a), die zweiten Spacer Sp2 entlang Flanken der Gateelektrode Ga1 des Transistors der Peripherie und die dritten Spacer Sp3 entlang Flanken der Gateelektrode Ga2 des Hochvolt-Transistors der Peripherie (s. Figur 6a,b,c). Da beim Rückätzen das Postoxid P teilweise weggeätzt wird, wird zur Erzeugung eines Streuoxids (nicht dargestellt) in einem TEOS-Verfahren ca. 10nm SiO₂ abgeschieden.

Anschließend wird ein Steg aus Fotolack F erzeugt, die Ränder der Gateelektrode Ga2 des Hochvolt-Transistors überlappt sowie einen sie umgebenden Bereich bedeckt, erzeugt (siehe Figur 6c).

Durch Implantation mit n-dotierenden Ionen werden ca. 150nm tiefe zweite Teile S/Dh der Source/Drain-Gebiete S/D der Transistoren der Speicherzellen, ca. 150 nm tiefe zweite Teile S/Dh1 der Source/Drain-Gebiete S/D1 des Transistors der Peripherie und ca. 150nm tiefe zweite Teile S/Dh2 der Source/Drain-Gebiete S/D2 des Hochvolt-Transistors der Peripherie erzeugt. Dabei dienen die ersten Spacer Sp1, die Wortleitungen, die zweiten Spacer Sp2, die Gateelektrode Ga1 des Transistors der Peripherie und der Steg aus Fotolack F als Maske. Die zweiten Teile S/Dh der Source/Drain-Gebiete S/D der Transistoren der Speicherzellen und die zweiten Teile S/Dh1 der Source/Drain-Gebiete S/D1 des Transistors der Peripherie entstehen also selbstjustiert (s. Figur 6a,b,c). Das Streuoxid und vom Steg aus Fotolack F nicht bedeckte Teile des Postoxids P werden mit z.B. HF entfernt. Der Steg aus Fotolack F wird entfernt.

Anschließend wird Titan in einer Dicke von ca. 30 nm abgeschieden. Durch Tempern wird eine selektive Silizierung durchgeführt, wodurch die Source/Drain-Gebiete S/D der Transistoren der Speicherzellen, die Source/Drain-Gebiete S/D1 des Transistors der Peripherie und Teile der Source/Drain-Gebiete S/D2 des Hochvolt-Transistors der Peripherie, die nicht vom Postoxid P bedeckt sind, die Wortleitungen, die Gateelektrode Ga1 des Transistors der Peripherie und Teile der Gateelektrode Ga2 des Hochvolt-Transistors der Peripherie, die nicht vom Postoxid P bedeckt sind, mit leitenden Strukturen L versehen werden (s. Figur 6a,b,c). Übrigbleibendes Titan wird mit z.B. H₂O₂/NH₃ entfernt.

Der erste Bereich des Substrats 1 ist der Bereich der Speicherzellen und der zweite Bereich ist der Bereich der Peripherie der Speicherzellenanordnung.

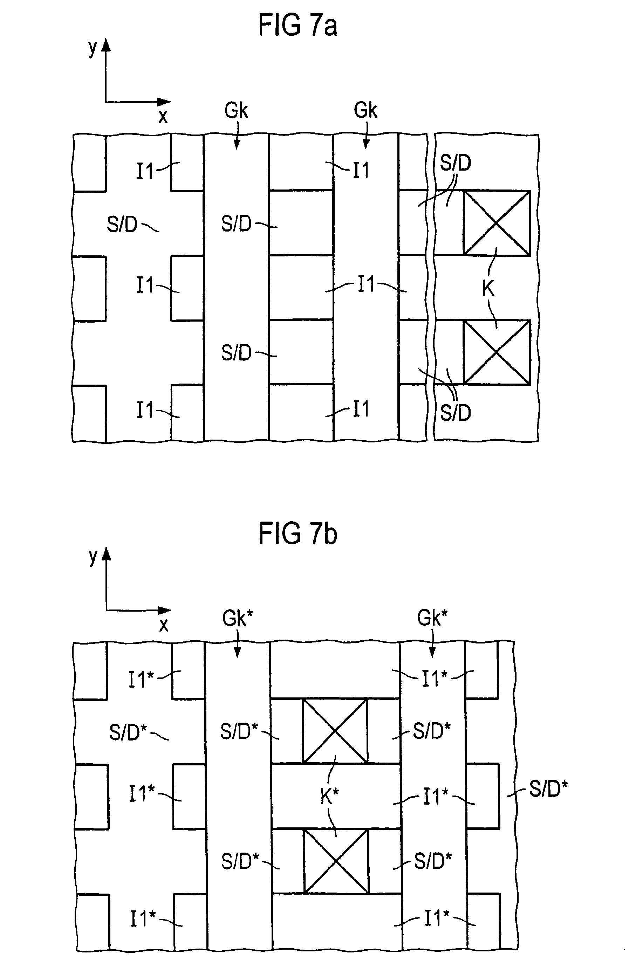

Die Speicherzellen sind in Blöcken zusammengefaßt. Zwei entlang der x-Achse X benachbarte erste isolierende Strukturen I1 gehören zu verschiedenen Blöcken. Ein Source/Drain-Gebiet (S/D) von entlang der x-Achse X benachbarten Transistoren ist mit einem Bitleitungs-Kontakt K versehen. Acht entlang der x-Achse X benachbarte Transistoren der Speicherzellen sind einem der Blöcke zugeordnet, sind in Reihe geschaltet und bilden Teile von Bitleitungen (s. Figur 7a).

Jede Speicherzelle der hergestellten Speicherzellenanordnung umfaßt einen planaren Transistor, dessen Kanalgebiet Ka an einem Boden einer der Vertiefungen V ausgebildet ist. Keine Verbindungslinie zwischen zwei Source/Drain-Gebieten S/D des Transistors verläuft parallel zur y-Achse Y und zum Verlauf der Wortleitung. Der Stromfluß des Transistors verläuft parallel zur x-Achse X. Senkrecht zur y-Achse Y benachbarte Transistoren teilen sich ein gemeinsames Source/Drain-Gebiet S/D.

Insbesondere können die Abmessungen der beschriebenen Schichten, Vertiefungen, Masken, Spacer und Strukturen nach Belieben an die jeweiligen Erfordernisse angepaßt werden. Dasselbe gilt auch für die vorgeschlagenen Dotierstoffkonzentrationen.

Es kann auch eine von acht verschiedene Zahl, z.B. sechzehn, von entlang der x-Achse X benachbarten Transistoren der Speicherzellen einem Block zugeordnet werden, die in Reihe geschaltet und bilden Teile von Bitleitungen sind. In diesem Fall wird die zur x-Achse X parallele Abmessung der ersten isolierenden Struktur so angepaßt, daß diese Transistoren an sie angrenzen.

Durch geringfügige Veränderung des Ausführungsbeispiels läßt sich eine elektrisch programmierbare Speicherzellenanordnung herstellen, bei der die entlang der y-Achse Y* benachbarten Transistoren parallel zueinander geschaltet sind. Dazu werden Bitleitungen erzeugt, die über Kontakte K* mit jeweils einem Source/Drain-Gebiet S/D* von jedem Transistor verbunden werden (s. Figur 7b). Zur x-Achse X* parallele Abmessungen der ersten isolierenden Strukturen I1* betragen z.B. 1000 nm, wenn zwischen entlang der x-Achse X* benachbarte erste isolierende Strukturen I1* ein gemeinsames Source/Drain-Gebiet S/D* von entlang der y-Achse Y* benachbarten Transistoren angeordnet ist und die benachbarten Transistoren bezüglich der y-Achse Y* achsensymmetrisch zueinander sind.

## Patentansprüche

1. Verfahren zur Herstellung einer elektrisch programmierbaren Speicherzellenanordnung,
- bei dem in einem Substrat (1) zwei erste isolierende Strukturen (I1) ausgebildet und zwischen den zwei ersten isolierenden Strukturen (I1) eine Vertiefung (V) erzeugt wird, die an die zwei ersten isolierenden Strukturen (I1) angrenzt und deren Boden mindestens teilweise mit einem ersten Dielektrikum (D1) versehen wird,
- bei dem in dem Substrat (1) ein Kanalgebiet (Ka) eines einer Speicherzelle zugeordneten planaren Transistors erzeugt wird, das an das erste Dielektrikum (D1) angrenzt,
- bei dem zwei Source/Drain-Gebiete (S/D) des Transistors so durch Implantation einer Oberfläche (O) des Substrats (1) gebildet werden, daß sie an zwei sich gegenüberliegenden Flanken der Vertiefung (V) angrenzen und daß ein zu einer Oberfläche (O) des Substrats (1) paralleler Querschnitt durch das Kanalgebiet (Ka) die Source/Drain-Gebiete (S/D) schneidet,
- bei dem die zwei Flanken der Vertiefung (V) mit einer Isolation (I) versehen werden,
- bei dem die Vertiefung (V) durch Aufbringen einer leitenden ersten Schicht (L1) verengt aber nicht ausgefüllt wird, und durch Strukturierung der leitenden ersten Schicht (L1) eine Floating-Gateelektrode (Gf) des Transistors erzeugt wird, wodurch die Floating-Gateelektrode (Gf) an das erste Dielektrikum (D1) und an die Isolation (I), die die Ausbildung einer Kapazität zwischen der Floating-Gateelektrode (Gf) und den Source/Drain-Gebieten (S/D) verhindert, angrenzt,
- bei dem über der Floating-Gateelektrode (Gf) ein zweites Dielektrikum (D2) und über das zweite Dielektrikum (D2) eine Kontroll-Gateelektrode (Gk) erzeugt werden.
**dadurch gekennzeichnet,**
- **dass** in dem Substrat (1) zusammen mit den ersten isolierenden Strukturen (I1) mindestens eine zweite isolierende Struktur (12) eines planaren Transistors einer Peripherie der Speicherzellenanordnung und eine dritte isolierende Struktur (I3) eines planaren Hochvolt-Transistors der Peripherie erzeugt werden,
- **dass** vor Erzeugung der Kontroll-Gateelektrode (Gk) ein Gatedielektrikum (Gd1) des Transistors der Peripherie und ein Gatedielektrikum (Gd2) des Hochvolt-Transistors der Peripherie erzeugt werden,
- **dass** eine zweite Schicht (L2) aufgebracht und strukturiert wird, wodurch die Kontroll-Gateelektrode (Gk), die Teil einer Wortleitung ist, eine Gateelektrode (Ga1) des Transistors der Peripherie und eine Gateelektrode (Ga2) des Hochvolt-Transistors der Peripherie entstehen,
- **dass** für die zwei Source/Drain-Gebiete (S/D) jeweils ein erster Teil (LDD) erzeugt wird, der an eine der zwei Flanken der Vertiefung (V) und an das Kanalgebiet (Ka) angrenzt,
- **dass** die ersten Teile (LDD) der zwei Source/Drain-Gebiete (S/D) des Transistors der Speicherzelle, erste Teile (LDD1) von Source/Drain-Gebieten (S/D1) des Transistors der Peripherie und erste Teile (LDD2) von Source/Drain-Gebieten (S/D2) des Hochvolt-Transistors der Peripherie durch Implantation erzeugt werden, wobei die Wortleitung, die Gateelektrode (Ga1) des Transistors der Peripherie und die Gateelektrode (Ga2) des Hochvolt-Transistors der Peripherie als Masken wirken,
- **dass** nach Erzeugung der Wortleitung Material abgeschieden und rückgeätzt wird, wodurch entlang Flanken der Wortleitung Spacer (Sp1) entstehen,
- **dass** zusammen mit den Spacern (Sp1) weitere Spacer (Sp2) an Flanken der Gateelektrode des Transistors der Peripherie (Ga1) erzeugt werden, und
- **dass** für die zwei Source/Drain-Gebiete (S/D) durch Implantation mit Hilfe der Spacer (Sp1) als Maske jeweils ein zweiter Teil (S/Dh) erzeugt wird, der höher als der erste Teil (LDD) dotiert ist und an ihn angrenzt,
- wobei zusammen mit den zweiten Teilen (S/Dh) der zwei Source/Drain-Gebiete (S/D) des Transistors der Speicherzelle zweite Teile (S/Dh1) der Source/Drain-Gebiete (S/D1) des Transistors der Peripherie und zweite Teile (S/Dh2) der Source/Drain-Gebiete (S/D2) des Hochvolt-Transistors der Peripherie erzeugt werden, wobei mindestens die Spacer (Sp1) und die weiteren Spacer (Sp2) als Maske wirken.

2. Verfahren nach Anspruch 1,
- dass die Vertiefung (V) zwischen zwei ersten isolierenden Strukturen (I1) erzeugt wird, die zwei weitere Flanken der Vertiefung (V) bilden,
- bei dem die Floating-Gateelektrode (Gf) so strukturiert wird, daß sie auch an die ersten isolierenden Strukturen (I1) und damit an mindestens vier Flanken der Vertiefung (V) angrenzt.

3. Verfahren nach einem der Ansprüche 1 oder 2,
- bei dem nach Erzeugung der leitenden ersten Schicht (L1) zur Erzeugung der Floating-Gateelektrode (Gf) Planarisierungs-Material abgeschieden und planarisiert wird, bis au-ßerhalb der Vertiefung (V) befindliche Teile der leitenden ersten Schicht (L1) freigelegt werden,
- bei dem planarisiert wird, bis die außerhalb der Vertiefung (V) befindlichen Teile der leitenden ersten Schicht (L1) entfernt werden, wodurch die Floating-Gateelektrode (Gf) entsteht, die aus der Vertiefung (V) nicht herausragt.

4. Verfahren nach einem der Ansprüche 1 bis 3,
- bei dem zwischen zwei quer zur Wortleitung zueinander benachbarten Vertiefungen ein gemeinsames Source/Drain-Gebiet zweier Transistoren erzeugt wird,
- bei dem eine Bitleitung durch quer zur Wortleitung zueinander benachbarte in Reihe geschaltete Transistoren gebildet wird.

5. Verfahren nach einem der Ansprüche 1 bis 4,
- bei dem zwischen zwei quer zur Wortleitung zueinander benachbarten Vertiefungen ein gemeinsames Source/Drain-Gebiet zweier Transistoren erzeugt wird,
- bei dem eine Bitleitung erzeugt wird, die mit jeweils einem Source/Drain-Gebiet von quer zur Wortleitung zueinander benachbarten Transistoren verbunden wird.

## Claims

1. Method for fabricating an electrically programmable memory cell arrangement,
- in which two first insulating structures (I1) are formed in a substrate (1) and a depression (V) is produced between the two first insulating structures (I1), which depression adjoins the two first insulating structures (I1) and the bottom of which depression is at least partially provided with a first dielectric (D1),
- in which a channel region (Ka) of a planar transistor assigned to a memory cell is produced in the substrate (1), which channel region adjoins the first dielectric (D1),
- in which two source/drain regions (S/D) of the transistor are formed by implantation of a surface (O) of the substrate (1), in such a way that they adjoin two mutually opposite sidewalls of the depression (V) and that a cross section through the channel region (Ka), said cross section being parallel to a surface (O) of the substrate (1), intersects the source/drain regions (S/D),
- in which the two sidewalls of the depression (V) are provided with insulation (I),
- in which the depression (V) is constricted, but not filled, by the application of a conductive first layer (L1), and a floating gate electrode (Gf) of the transistor is produced by patterning of the conductive first layer (L1), as a result of which the floating gate electrode (Gf) adjoins the first dielectric (D1) and the insulation (I), which prevents the formation of a capacitance between the floating gate electrode (Gf) and the source/drain regions (S/D),
- in which a second dielectric (D2) is produced above the floating gate electrode (Gf) and a control gate electrode (Gk) is produced above the second dielectric (D2),
**characterized**
- **in that** at least one second insulating structure (I2) of a planar transistor of a periphery of the memory cell arrangement and a third insulating structure (I3) of a planar high-voltage transistor of the periphery are produced in the substrate (1) together with the first insulating structures (I1),
- **in that**, before the control gate electrode (Gk) is produced, a gate dielectric (Gd1) of the transistor of the periphery and a gate dielectric (Gd2) of the high-voltage transistor of the periphery are produced,
- **in that** a second layer (L2) is applied and patterned, thereby producing the control gate electrode (Gk), which is part of a word line, a gate electrode (Ga1) of the transistor of the periphery and a gate electrode (Ga2) of the high-voltage transistor of the periphery,
- **in that** a first part (LDD) is produced for each of the two source/drain regions (S/D), which part adjoins one of the two sidewalls of the depression (V) and the channel region (Ka),
- **in that** the first parts (LDD) of the two source/drain regions (S/D) of the transistor of the memory cell, first parts (LDD1) of source/drain regions (S/D1) of the transistor of the periphery and first parts (LDD2) of source/ drain regions (S/D2) of the high-voltage transistor of the periphery are produced by implantation, the word line, the gate electrode (Ga1) of the transistor of the periphery and the gate electrode (Ga2) of the high-voltage transistor of the periphery acting as masks,
- **in that** after the word line has been produced, material is deposited and etched back, spacers (Sp1) thereby being produced along sidewalls of the word line,
- **in that**, together with the spacers (Sp1), further spacers (Sp2) are produced on sidewalls of the gate electrode of the transistor of the periphery (Ga1), and
- **in that** a second part (S/Dh) is produced for each of the two source/drain regions (S/D) by implantation with the aid of the spacers (Sp1) as mask, which second part is doped more heavily than the first part (LDD) and adjoins it,
- wherein, together with the second parts (S/Dh) of the two source/drain regions (S/D) of the transistor of the memory cell, second parts (S/Dh1) of the source/drain regions (S/D1) of the transistor of the periphery and second parts (S/Dh2) of the source/drain regions (S/D2) of the high-voltage transistor of the periphery are produced, at least the spacers (Sp1) and the further spacers (Sp2) acting as mask.

2. The method as claimed in Claim 1,
- in which the depression (V) is produced between two first insulating structures (I1), which form two further sidewalls of the depression (V),
- in which the floating gate electrode (Gf) is patterned in such a way that it also adjoins the first insulating structures (I1) and thus at least four sidewalls of the depression (V).

3. The method as claimed in one of Claims 1 or 2,
- in which, after the conductive first layer (L1) has been produced, in order to produce the floating gate electrode (Gf), planarization material is deposited and planarized until parts of the conductive first layer (L1) which are located outside the depression (V) are uncovered,
- in which planarization is effected until the parts of the conductive first layer (L1) which are located outside the depression (V) are removed, a floating gate electrode (Gf)thereby being produced which does not project from the depression (V) .

4. The method as claimed in one of Claims 1 to 3,
- in which a common source/drain region of two transistors is produced between two depressions which are adjacent to one another transversely with respect to the word line,
- in which a bit line is formed by series-connected transistors which are adjacent to one another transversely with respect to the word line.

5. The method as claimed in one of Claims 1 to 4,
- in which a common source/drain region of two transistors is produced between two depressions which are adjacent to one another transversely with respect to the word line,
- in which a bit line is produced which is connected to a respective source/drain region (S/D) of transistors which are adjacent to one another transversely with respect to the word line.

## Revendications

1. Procédé de production d'une configuration de cellule de mémoire programmable électriquement,
- dans lequel on forme deux premières structures (I1) isolantes dans un substrat (1) et on produit entre les deux premières structures (I1) isolantes une cavité (V), qui est voisine des deux premières structures (I1) isolantes et dont le fond est mis au moins en partie d'un premier diélectrique (D1),
- dans lequel on produit dans le substrat (1) une zone (Ka) de canal d'un transistor planaire associé à une cellule de mémoire, zone qui est voisine du premier diélectrique (D1),
- dans lequel on forme deux zones (S/D) de source/drain du transistor par implantation d'une surface (O) du substrat (1), de façon à ce qu'elles soient voisines de deux plans opposés de la cavité (V) et de façon à ce qu'une section transversale, parallèle à une surface (O) du substrat (1), de la zone (Ka) de canal coupe les zones (S/D) de source/drain,
- dans lequel on munit les deux flancs de la cavité (V) d'un isolant (I),
- dans lequel on rétrécit, mais sans la remplir, la cavité (V) par dépôt d'une première couche (L1) conductrice et on produit une électrode (Gf) de grille flottante du transistor en structurant la première couche (L1) conductrice, de sorte que l'électrode (Gf) de grille flottante est voisine du premier diélectrique (D1) et de l'isolant (I) qui empêchent la formation d'une capacité entre l'électrode (Gf) de grille flottante et les zones (S/D) de source/drain,
- dans lequel on produit au-dessus de l'électrode (Gf) de grille flottante un deuxième diélectrique (D2) et au-dessus du deuxième diélectrique (D2) une électrode (Gk) de grille de contrôle,
**caractérisé**
- **en ce que** l'on produit dans le substrat (1), ensemble avec les premières structures (I1) isolante, au moins une deuxième structure (I2) isolante d'un transistor planaire d'une périphérie de la configuration de cellule de mémoire et une troisième structure (I3) isolante d'un transistor planaire de haute tension de la périphérie,
- **en ce que**, avant la production de l'électrode (Gk) de grille de contrôle, on produit un diélectrique (Gd1) de grille du transistor de la périphérie et un diélectrique (Gd2) de grille du transistor de haute tension de la périphérie,
- **en ce que** l'on dépose et structure une deuxième couche (L2) de manière à créer l'électrode (Gk) de grille de contrôle qui fait partie d'une ligne de mots, une électrode (Ga1) de grille du transistor de la périphérie et une électrode (Ga2) de grille du transistor de haute tension de la périphérie,
- **en ce que** l'on produit pour les deux zones (S/D) de source/drain respectivement une première partie (LDD), qui est voisine de l'un des deux flancs de la cavité (V) et de la zone (Ka) de canal,
- **en ce que** l'on produit les premières parties (LDD) des deux zones (S/D) de source/drain du transistor de la cellule de mémoire des premières parties (LDD1) de zone (S/D1) de source/drain du transistor de la périphérie et des premières parties (LDD2) de zone (S/D2) de source/drain du transistor de haute tension de la périphérie par implantation, la ligne de mots, l'électrode (Ga1) de grille du transistor de la périphérie et l'électrode (Ga2) de grille du transistor de haute tension de la périphérie servant de masques,
- **en ce que**, après la production de la ligne de mots, on dépose de la matière et on l'attaque en retrait, en créant ainsi des espaceurs (Sp1) le long des flancs de la ligne de mots,
- **en ce que** l'on produit, ensemble avec les espaceurs (Sp1), d'autres espaceurs (Sp2) sur des flancs de l'électrode de grille du transistor de la périphérie (Ga1), et
- **en ce que** l'on produit pour les deux zones (S/D) de source/drain par implantation à l'aide des espaceurs (Sp1) comme masque, respectivement une deuxième partie (S/Dh) qui est davantage dopée que la première partie (LDD) et qui en est voisine,
- dans lequel on produit, ensemble avec les deuxièmes parties (S/Dh) des deuxièmes zones (S/D) de source/drain du transistor de la cellule de mémoire, des deuxièmes parties (S/Dh1) des zones (S/D1) de source/drain du transistor de la périphérie et des deuxièmes parties (S/Dh2) des zones (S/D2) de source/drain du transistor de haute tension de la périphérie, au moins les espaceurs (Sol) et les autres espaceurs (Sp2) servant de masques.

2. Procédé suivant la revendication 1,
- en ce que l'on produit la cavité (V) entre deux premières structures (I1) isolantes qui forment deux autres flancs de la cavité (V),
- dans lequel on structure l'électrode (Gf) de grille flottante de façon à ce qu'elle soit voisine aussi des premières structures (I1) isolantes et ainsi voisines d'au moins quatre flancs de la cavité (V).

3. Procédé suivant l'une des revendications 1 ou 2,
- dans lequel, après production de la première couche (L1) conductrice, on dépose et on planarise, pour la production d'électrode (Df) de grille flottante, de la matière de planarisation et on planarise jusqu'à mettre à nu des parties de la première couche (L1) conductrice se trouvant à l'extérieur de la cavité (V),
- dans lequel on planarise jusqu'à ce que les parties de la première couche (L1) conductrice se trouvant à l'extérieur de la cavité (V) soient éliminées, en créant ainsi l'électrode (Gf) de grille flottante qui ne dépasse pas de la cavité (V).

4. Procédé suivant l'une des revendications 1 à 3,
- dans lequel on produit entre deux cavités voisines l'une de l'autre, transversalement à la ligne de mots, une zone commune de source/drain de deux transistors,
- dans lequel on forme une ligne de bits par des transistors montés en série et voisins l'un de l'autre, transversalement à la ligne de mots.

5. Procédé suivant l'une des revendications 1 à 4,
- dans lequel on produit entre deux cavités voisines l'une de l'autre, transversalement à la ligne de mots, une zone commune de source/drain de deux transistors,
- dans lequel on produit une ligne de bits qui est reliée à respectivement une zone de source/drain de transistors voisins l'un de l'autre, transversalement à la ligne de mots.
